(19) **Europäisches Patentamt**
**European Patent Office**
**Office européen des brevets**

(11) **EP 2 128 308 B1**

(12) **EUROPEAN PATENT SPECIFICATION**

(45) Date of publication and mention
of the grant of the patent:
**14.03.2012 Bulletin 2012/11**

(51) Int Cl.:
***C30B 13/00*** *(2006.01)*

(21) Application number: **07706464.0**

(22) Date of filing: **10.01.2007**

(86) International application number:
**PCT/JP2007/050117**

(87) International publication number:
**WO 2008/084529 (17.07.2008 Gazette 2008/29)**

(54) **FLOATING ZONE MELTING APPARATUS**

VORRICHTUNG ZUM TIEGELFREIEN ZONENSCHMELZEN

APPAREIL DE FUSION À ZONE FLOTTANTE

(84) Designated Contracting States:
**AT BE BG CH CY CZ DE DK EE ES FI FR GB GR
HU IE IS IT LI LT LU LV MC NL PL PT RO SE SI
SK TR**

(43) Date of publication of application:
**02.12.2009 Bulletin 2009/49**

(73) Proprietor: **CRYSTAL SYSTEMS CORPORATION
Yamanashi 408-0044 (JP)**

(72) Inventor: **SHINDO, Isamu
Hokuto-shi
Yamanashi 408-0041 (JP)**

(74) Representative: **Hall, Matthew Benjamin
Dehns
St. Bride's House
10 Salisbury Square
London EC4Y 8JD (GB)**

(56) References cited:
**EP-A2- 0 768 391      JP-A- 09 235 171
JP-A- 57 092 594      JP-A- 57 095 890
JP-A- 2001 192 290    JP-A- 2005 219 996**

- **EYER A ET AL: "A DOUBLE-ELLIPSOID MIRROR
FURNACE FOR ZONE CRYSTALLIZATION
EXPERIMENTS IN SPACELAB" JOURNAL OF
CRYSTAL GROWTH, ELSEVIER, AMSTERDAM,
NL LNKD- DOI:10.1016/0022-0248(79)90245-8,
vol. 47, no. 2, 1 August 1979 (1979-08-01), pages
219-229, XP002035383 ISSN: 0022-0248**
- **SHINDO I: "NEW 4-MIRROR TYPE OPTICAL
FLOATING ZONE FURNACE" JOURNAL OF
CRYSTAL GROWTH, ELSEVIER, AMSTERDAM,
NL, vol. 161, no. 1/04, 1 April 1996 (1996-04-01),
page A, XP000626729 ISSN: 0022-0248**

EP 2 128 308 B1

## Description

TECHNICAL FIELD

The present invention relates to a floating zone melting apparatus of an infrared intensive heating system in which an infrared lamp is disposed at one focal point of a rotary ellipsoidal reflecting mirror and infrared rays reflected from a reflecting surface of the rotary ellipsoidal reflecting mirror are collected to the other focal point, thereby heating and dissolving a sample and growing a single crystal using the floating zone melting apparatus.

BACKGROUND ART

A floating zone melting apparatus of an infrared intensive heating system is provided with the following advantages and is widely used for growing a single crystal and for researching phase equilibrium.

(I) A sample can be molten without using a crucible.
(II) An atmospheric gas can be selected freely.
(III) A growth of a single crystal composed of a variety of components can be carried out by utilizing a floating zone method.
(IV) The phase equilibrium can be researched by a floating zone slow cooling method.
(V) A high temperature can be easily achieved by a comparatively small electric power.

A use of a floating zone melting apparatus for growing a single crystal requires the conditions such as that a high temperature can be achieved at a molten part of a sample, a temperature is uniform in the circumferential direction around a bar axis of a sample, a temperature distribution in the vertical direction (a direction of a bar axis of a sample) is steep, a local heating can be easily carried out, and a molten solution can be easily held in a sample bar. The floating zone melting apparatuses of an infrared intensive heating system based on a variety of types have been developed in order to satisfy the above conditions.

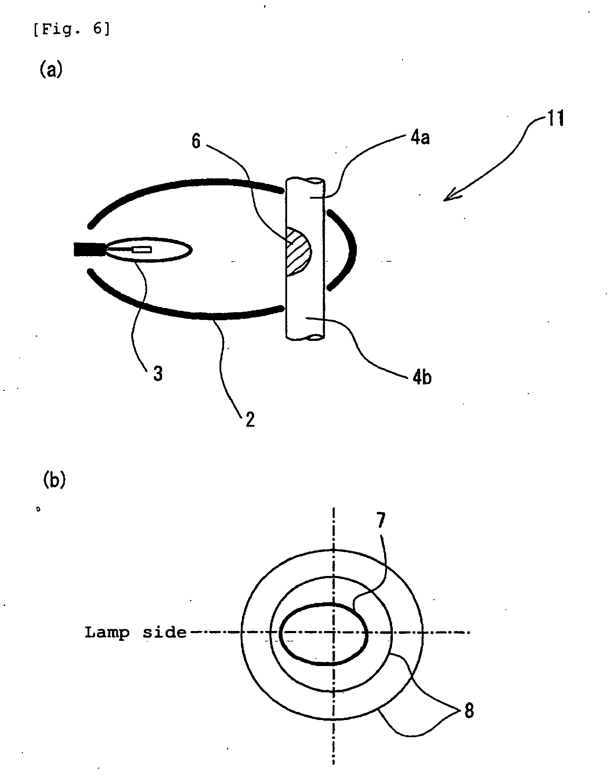

Fig. 6(a) is a view for illustrating a conventional floating zone melting apparatus of an infrared intensive heating system in which a single elliptical mirror furnace is used, and indicates the state in which a sample bar 4a in a round bar shape is heated in a single elliptical mirror furnace 11. In the floating zone melting apparatus, one elliptical mirror 2 is used, and an infrared lamp 3 such as a halogen lamp and a xenon lamp is disposed at one focal point of two focal points thereof. The elliptical mirror 2 is a metallic mirror. An infrared ray that is emitted from the infrared lamp 3 and from one focal point is reflected from the elliptical mirror 2 and collected to the other focal point. The sample bar 4a is heated at the focal point to which infrared rays are collected, and a molten material is formed. The gradual relative displacement of the sample bar 4a and the infrared lamp 3 in an axial direction enables a growth crystal 4b to be grown in a bar shape.

For the system in which the single elliptical mirror furnace 11 is used, a utilization efficiency of the infrared lamp 3 is highest. However, a temperature of the sample bar 4a region on a side opposite to a side of the infrared lamp 3 is hard to be increased, and a temperature of a region 5 on the side of the infrared lamp 3 is higher in comparison. As shown in Fig. 6(b), a temperature distribution occurs in the circumferential direction around a bar axis on a horizontal plane of a molten part of the sample bar 4a (a numeral 7 represents an isothermal line, and 8 represents an equidistant curve from the central axis of the sample bar 4a).

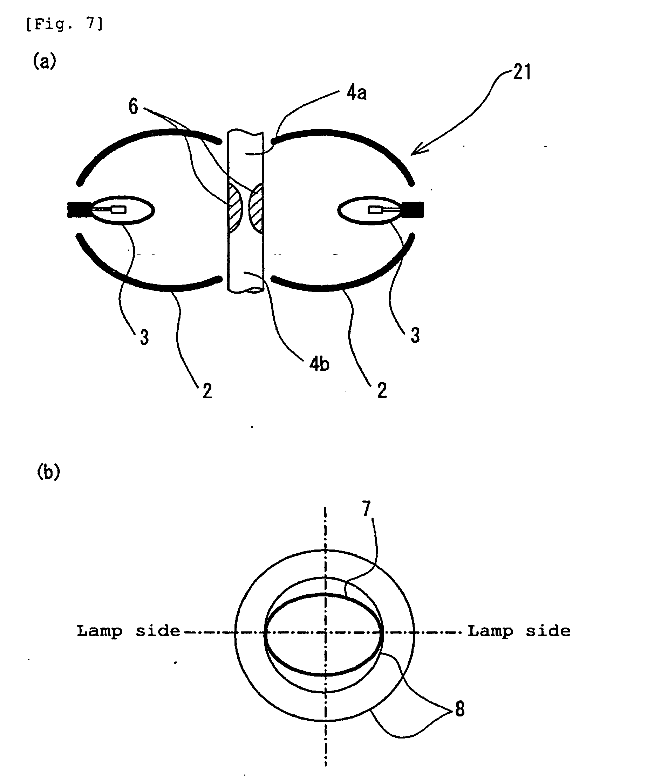

To improve a bias of the temperature distribution, an apparatus provided with a twin elliptical mirror furnace 21 as shown in Fig. 7(a) has been developed. In this floating zone melting apparatus, a pair of elliptical mirrors 2 in which a part of an ellipse is cut is disposed in the same straight line in a transverse direction in such a manner that one focal point is shared, and a sample bar 4a is heated from the both sides by a pair of infrared lamps 3 disposed at the other focal point of the elliptical mirrors 2.

For the system in which the twin elliptical mirror furnace 21 is used, the sample bar 4a can be heated from the both sides in a transverse direction, whereby a temperature distribution in the circumferential direction can be improved as compared with the single elliptical mirror furnace. However, a temperature distribution occurs in the circumferential direction of the sample bar 4a as shown in Fig. 7(b), that is, a temperature in a direction perpendicular to a direction of a disposal of a pair of infrared lamps 3 is lower.

An actual degree of a difference in a temperature in the circumferential direction depends on a size and a shape of a filament of the infrared lamp 3 to be used. In a normal use method, a difference in a temperature is approximately 100°C or larger than 100°C in many cases for both of a single elliptical mirror furnace and a twin elliptical mirror furnace. As a means for reducing a difference in a temperature, a lamp having a filament size larger than a size of a light collecting region can be used, whereby a difference in a temperature can be decreased to some extent. However, in the case in which a single crystal is tried to be grown by a floating zone melting method based on such a light collecting system, a temperature gradient in the vertical direction is slow, and a formed molten material may be dropped. Consequently, to grow a single crystal by a floating zone melting method in particular, it is required not only that a temperature gradient in the circumferential direction is made to be uniform but also that a temperature gradient in the vertical direction is maintained to be steep simultaneously.

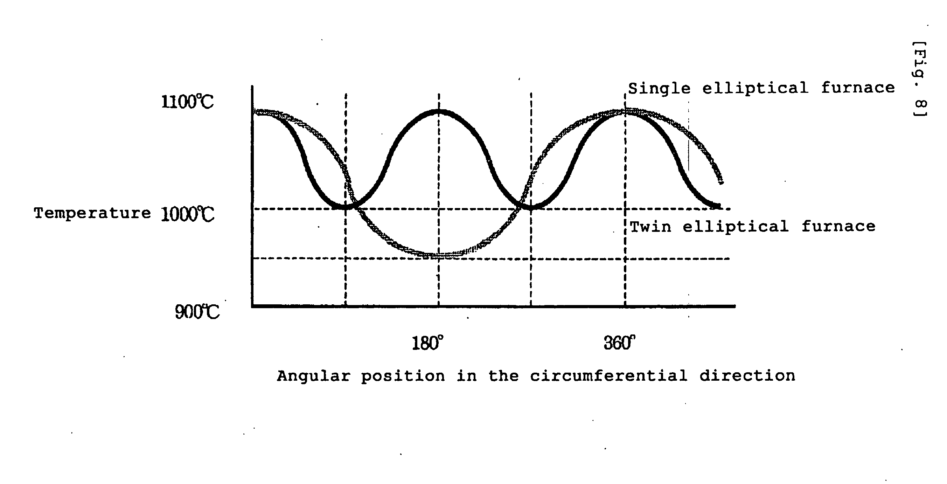

Fig. 8 shows an example of a temperature distribution in the circumferential direction for a molten part in a single elliptical mirror furnace and a twin elliptical mirror furnace. As shown in the example, a difference in a temperature of a maximum temperature part and a minimum temperature part reaches 10% of a maximum temperature value. As a matter of course, the condition in which such a temperature distribution occurs is not preferable in the case in which a single crystal of a high quality is grown.

An apparatus of a four elliptical mirror type has been developed to further improve a bias of the temperature distribution (Patent document 1). In the apparatus, two elliptical mirrors are added to the twin elliptical mirror furnace, four elliptical mirrors that share one focal point with each other are disposed on orthogonal axes, and a sample bar can be heated from four directions.

Patent document 1: Japanese Patent Application Laid-Open Publication No. 9-235171

A similar apparatus is disclosed in EP-A-0768391 wherein the mirrors have an eccentricity within a range from 0.4 to 0.65

DISCLOSURE OF THE INVENTION

PROBLEMS TO BE SOLVED BY THE INVENTION

A temperature distribution in the circumferential direction has been greatly improved by the system for heating a sample bar from four directions by using the four elliptical mirrors. However, for a growth of a single crystal, it is required that a temperature distribution in the circumferential direction is uniform, a temperature gradient in the vertical direction is steep as described above, and a maximum achieving temperature is satisfactorily high. For a conventional apparatus of a four elliptical mirror type, although a maximum achieving temperature can be increased, a temperature gradient in the vertical direction is slow, whereby a molten solution may be easily dropped, and it is difficult to keep a stable molten zone disadvantageously. An apparatus that can satisfy the above all conditions has not been implemented.

Moreover, after a machining of an elliptical mirror, gold metal plating has been applied to a surface of the mirror to form a metallic mirror to be used. For this system, a production cost of the metallic mirror is extremely high. In addition, it is difficult to improve a machining accuracy of a surface as compared with a glass mirror, and a steep temperature gradient in the vertical direction cannot be achieved disadvantageously.

An object of the present invention is to provide a floating zone melting apparatus of an infrared intensive heating system in which a difference in a temperature in the circumferential direction of a sample in a molten part is small, a temperature gradient in the vertical direction thereof is steep, a satisfactorily high maximum achieving temperature can be realized, and a stable molten state can be achieved. Moreover, another object of the present invention is to provide a high performance single crystal synthesizing apparatus provided with an oblique irradiation mechanism from an oblique upper direction for enabling a single crystal growth of a large diameter as compared with a case in which a conventional floating zone melting apparatus is used.

MEANS FOR SOLVING THE PROBLEMS

A floating zone melting apparatus of an infrared intensive heating system in accordance with the present invention is characterized by comprising an infrared lamp disposed at one focal point of four rotary ellipsoidal reflecting mirrors that are disposed opposite to each other on orthogonal axes with an inner face used as a reflecting surface, in which infrared rays reflected from the reflecting surface are collected to the other focal point to heat a sample, wherein:

an eccentricity of the rotary ellipsoidal reflecting mirror is in the range of 0.40 to 0.65, and a ratio of a depth of the reflecting mirror to a diameter of an opening in the reflecting mirror is in the range of 0.38 to 0.75.

Here, the above eccentricity is defined by the following expression:

$$(a^2-b^2)^{1/2}/a$$

(where a represents a length of a major axis of an ellipse, and b represents a length of a minor axis).

As described above, an eccentricity of an elliptical mirror and a ratio of a depth of the reflecting mirror to a diameter of an opening in the reflecting mirror are set in the prescribed range, whereby a glass mirror can be used as a material of an elliptical mirror. In a normal production method of a glass mirror, a mold of an elliptical mirror is fabricated at first, a softened glass plate is put on the mold, the glass plate is solidified, and the mold is removed. In the case in which a deep reflecting mirror is produced, the reflecting mirror cannot be removed from the mold. Consequently, it has been required to use a metallic mirror. However, this restriction can be canceled by the above configurations. In the case in which a glass mirror having a reflection efficiency higher than that of a metallic mirror is used, a light concentration performance can be improved, and a satisfactorily high maximum achieving temperature can be realized even in the case in which a depthless shallow elliptical mirror is used. As a result, the above configurations can solve the problem of a slow temperature gradient in the vertical direction caused by a use of four elliptical mirrors in the conventional system.

The floating zone melting apparatus in accordance with an embodiment of the present invention is further characterized in that the rotary ellipsoidal reflecting mirror is disposed in such a manner that a straight line from the one focal point to the other focal point is slanted downward, and infrared rays reflected from the reflecting surface are irradiated to a sample from an oblique upper direction. This configuration is implemented by using at least four depthless shallow elliptical mirrors. By the above configuration, a uniform and satisfactorily high maximum achieving temperature can be maintained. (Hereafter the apparatus is referred to as a gradient-type floating zone melting apparatus.) It is greatly significant that infrared rays can be uniformly irradiated to a sample from an oblique upper direction for growing a single crystal. Although the details will be described later, one of significances is that a single crystal of a large diameter can be grown. In a conventional floating zone melting method, a diameter of a single crystal to be grown cannot be larger disadvantageously. The floating zone melting apparatus in accordance with the present invention can resolve the most serious problem in a growth of a single crystal.

For a preferable mode of the above gradient-type floating zone melting apparatus, the six or eight rotary ellipsoidal reflecting mirrors are disposed at equal spaces. In the case in which a large-diameter single crystal having a diameter larger than 100 mm is grown, a use of six or eight elliptical mirrors enables a growth condition to be optimally controlled easily in some cases as compared with a system in which four elliptical mirrors are used.

For another preferable mode of the above gradient-type floating zone melting apparatus, the apparatus is provided with a position control mechanism for carrying out a horizontal movement of the rotary ellipsoidal reflecting mirror in a radial direction from a position in which the sample is disposed as a center. A mechanism for controlling the number, an angle of gradient, and a position for the rotary ellipsoidal reflecting mirrors is mounted. Consequently, a focal point can be easily set to an optimum position corresponding to an optical absorption property of a material and a degree of a diameter of a single crystal. Therefore, a single crystal can be stably grown in an optimum optical layout corresponding to a diameter of a single crystal.

For another preferable mode of the above gradient-type floating zone melting apparatus, the apparatus is provided with a heating part disposed on a lower side of a crystal growth part. By this configuration, not only a lamp but also a heating apparatus that is separately disposed on a lower side of a crystal growth part can be used as a heat source for forming a large amount of a source molten solution that is required for growing a single crystal of a large diameter. Consequently, a large amount of required molten materials can be easily formed. Therefore, a heat from a lamp can be concentrated to maintaining an optimum shape of an interface of solid and liquid phases for growing a single crystal of a high quality.

For another preferable mode of the above gradient-type floating zone melting apparatus, the apparatus is provided with a raw material melting furnace disposed on the upper side of the apparatus and a mechanism for dropping and supplying a molten raw material to the crystal growth part as needed. Moreover, it is preferable that the apparatus is provided with a raw material introduction pipe or a raw material introduction bar for supplying a molten raw material from the raw material melting furnace disposed on the upper side of the apparatus to the crystal growth part. In the case in which a single crystal is tried to be grown by a floating zone melting method, it is necessary to process a raw material in a bar shape. In the case in which such a sample in a bar shape cannot be used, raw material powder or a raw material chip is molten in a melting furnace in advance, and a molten solution is then introduced to a crystal growth part, thereby enabling a prescribed single crystal growth.

For another preferable mode of the above gradient-type floating zone melting apparatus, the apparatus is provided with a mechanism for controlling a pressure from a vacuum to a high pressure to the crystal growth part, a raw material molten part, and a raw material supplying part, and a mechanism for controlling an atmosphere using any gas from an oxidation gas to a reducing gas to the crystal growth part, the raw material molten part, and the raw material supplying part.

In the case in which a single crystal is tried to be grown by a floating zone melting method and infrared rays are used as a heat source, it is necessary for a target substance to have an infrared ray absorbing power. By this, infrared rays are absorbed into the substance, and a temperature of the substance is increased, whereby the substance is molten at last. Irradiated infrared rays are attenuated rapidly by absorption. Consequently, even in the case in which a molten material of a large diameter is tried to be formed, infrared rays do not reach the center of a substance, and it is difficult to increase a temperature of the center. This is the most important element of a reason why it is hard to apply a conventional infrared ray floating zone melting method to a growth of a single crystal of a large diameter.

However, the advantages of a growth of a single crystal based on an infrared ray floating zone melting method are extremely great. As described before, it is not necessary to use a vessel such as a crucible in an infrared ray floating zone melting method, whereby a production cost can be extremely reduced and a composition of a single crystal that is grown can be uniform. A conventional most important method for growing a single crystal of a large diameter is a pull method. In this method, a formed molten solution is stored in a crucible, and a single crystal is grown from the crucible. Consequently, a reaction with the crucible cannot be avoided. In addition, it is known that a special device such as a double crucible system is required for making a concentration of impurities in a single crystal that is grown to be uniform. In a current industry, silicon which is a most important single crystal material is grown by a pull method. In this case, a reaction with quartz that is used as a crucible causes oxygen to be introduced into a single crystal disadvantageously. Moreover, a concentration of impurities such as boron and phosphorus that are added to be used as a semiconductor cannot be uniform. Consequently, it is required for a use to remove a concentration unacceptable part of a single crystal that has been grown. As a method for growing a single crystal that does not include oxygen, a silicon single crystal is industrially grown by a floating zone melting method based on a high frequency induction heating method. However, a reachable depth of a high frequency is restricted, and it is thought that it is difficult to grow a large-diameter single crystal having a diameter larger than 200 mm. Since a solid and a molten material, which are made of the same substance, are different in a resistance value, it is said that extremely advanced experiences and techniques are required for creating and maintaining a stable molten material in the high frequency induction heating method. Similarly in an infrared ray floating zone melting method, a solid and liquid are different in an absorbing power of an infrared ray, and there is a substance that is difficult to be controlled. However, the difference of an absorbing power is not so disadvantageous in the case of many oxides and a semiconductor such as silicon, and a single crystal of a large diameter can be easily grown.

EFFECT OF THE INVENTION

By a floating zone melting apparatus in accordance with the present invention, a temperature gradient in the circumferential direction of a sample in a molten part is small, a temperature gradient in the vertical direction thereof is steep, a satisfactorily high maximum achieving temperature can be realized, a stable molten state can be achieved, and a growth of a single crystal of a larger diameter is enabled as compared with a conventional method.

BRIEF DESCRIPTION OF THE DRAWINGS

Fig. 1 is a view showing an elliptical mirror furnace of a floating zone melting apparatus in accordance with an embodiment of the present invention. Fig. 1 (a) is a longitudinal cross-sectional view, and Fig. 1 (b) is a transverse cross-sectional view.
Fig. 2 is a cross-sectional view showing a rotary ellipsoidal reflecting mirror of the elliptical mirror furnace of Fig. 1.
Fig. 3 is a view showing a temperature distribution in the circumferential direction for a molten part in the case in which the elliptical mirror furnace of Fig. 1 is used.
Fig. 4 is a view showing an elliptical mirror furnace of a floating zone melting apparatus in accordance with another embodiment of the present invention. Fig. 4(a) is a longitudinal cross-sectional view, and Fig. 4(b) is a transverse cross-sectional view.
Fig. 5 is a graph showing a temperature distribution in a vertical direction in the case in which a ratio of a depth of a reflecting mirror and a diameter of an opening of the reflecting mirror is changed.
Fig. 6(a) is a view for illustrating a conventional floating zone melting apparatus of an infrared intensive heating system in which a single elliptical mirror furnace is used, and indicates the state in which a sample bar is heated in the single elliptical mirror furnace.
Fig. 6(b) is a view for showing a temperature distribution in the circumferential direction for a molten part in the case in which the apparatus is used.
Fig. 7(a) is a view for illustrating a conventional floating zone melting apparatus of an infrared intensive heating system in which a twin elliptical mirror furnace is used, and indicates the state in which a sample bar is heated in the twin elliptical mirror furnace.
Fig. 7(b) is a view for showing a temperature distribution in the circumferential direction for a molten part in the case in which the apparatus is used.
Fig. 8 is a graph showing a temperature distribution in the circumferential direction for a molten part in a single elliptical furnace and a twin elliptical furnace.
Fig. 9 is a view for illustrating a relationship between an eccentricity and a size of a focus.

EXPLANATIONS OF LETTERS OR NUMERALS

1:      Elliptical mirror furnace

2:      Elliptical mirror

2a:     Elliptical mirror

2b:     Elliptical mirror

3:      Infrared lamp

4a:     Sample bar

4b:     Growth crystal

4c:     Molten part

5:      Position control mechanism

6:      High temperature region

7:      Isothermal line

8:      Equidistant curve from the central axis

9:      Focus part

10:     Opening

11: Single elliptical mirror furnace

12: Elliptical mirror

21: Twin elliptical mirror furnace

BEST MODE OF CARRYING OUT THE INVENTION

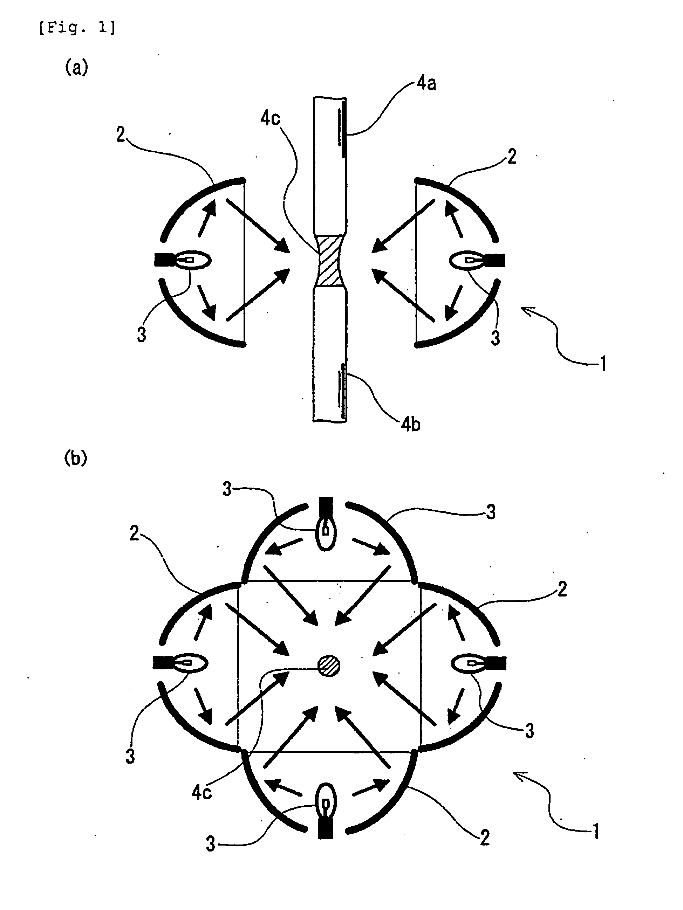

An embodiment (example) of the present invention will be described below in detail with reference to the drawings. Fig. 1 is a view showing an elliptical mirror furnace of a floating zone melting apparatus in accordance with an embodiment of the present invention. Fig. 1(a) is a longitudinal cross-sectional view, and Fig. 1(b) is a transverse cross-sectional view. As shown in the figure, four rotary ellipsoidal reflecting mirrors (elliptical mirrors 2) are disposed on orthogonal axes in such a manner that a sample bar 4a is surrounded by the four rotary ellipsoidal reflecting mirrors in an elliptical mirror furnace 1. The four elliptical mirrors 2 share the focal point with each other at the center position in which the sample bar 4a is disposed.

A filament of the infrared lamp 3 is disposed at a focal point on the side opposite to a light collecting side of each of the elliptical mirrors 2. Infrared rays that have been emitted from the filament are reflected from the elliptical mirrors 2 and collected at the other focal point to heat the sample bar 4a.

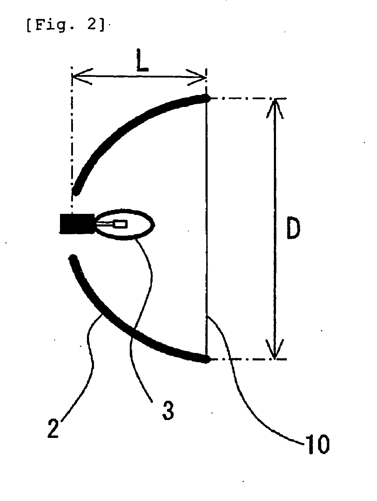

As shown in Fig. 2, for the four elliptical mirrors 2, a cross sectional shape in a direction of a major axis thereof is a shape in which a part of an ellipse is vertically cut from a light collecting side, and a cross sectional shape perpendicular to a direction of a major axis is a circle. A circular opening 10 is formed at the end of the light collecting side of the elliptical mirror 2.

An eccentricity of the elliptical mirror 2 is in the range of 0.40 to 0.65, and a ratio L/D of a depth L of the elliptical mirror 2 to a diameter D of the opening 10 in the reflecting mirror is in the range of 0.38 to 0.75. By configuring a shape of the elliptical mirror 2 b in the above range, a temperature gradient in a vertical direction of the sample bar 4a is steep, a satisfactorily high maximum achieving temperature can be realized, and a stable molten state can be achieved. In the case in which an eccentricity is less than 0.40 or L/D is less than 0.38, a maximum achieving temperature is lowered. In the case in which an eccentricity exceeds 0.65 or L/D exceeds 0.75, a temperature gradient in a vertical direction of the sample bar 4a is slow, whereby a growth of a single crystal is affected negatively, and a molten solution is dropped in some cases.

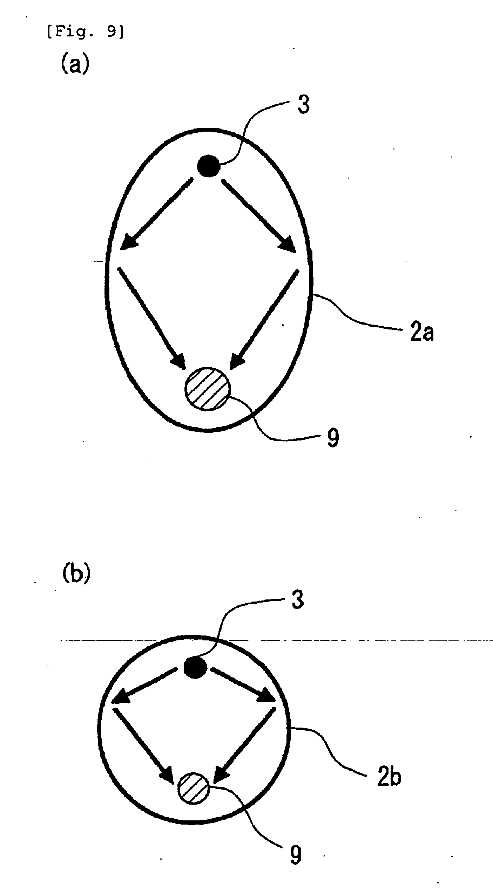

For an elliptical mirror 2a in which an eccentricity is large as shown in Fig. 9(a) for instance, a utilization efficiency of infrared rays that are emitted from the infrared lamp 3 can be maintained to be high. However, an area of a focus part 9 is enlarged, and a temperature gradient in a vertical direction is slow.

On the other hand, for an elliptical mirror 2b in which an eccentricity is small as shown in Fig. 9(b), an area of a focus part 9 can be reduced. However, it is required to dispose four elliptical mirrors in which overlapped parts have been cut in such a manner that adjacent elliptical mirrors do not overlap with each other. Consequently, a utilization efficiency of lights is deteriorated for a cut part of an ellipse, and a maximum achieving temperature is lowered in a region in which a stable molten state is required to be achieved.

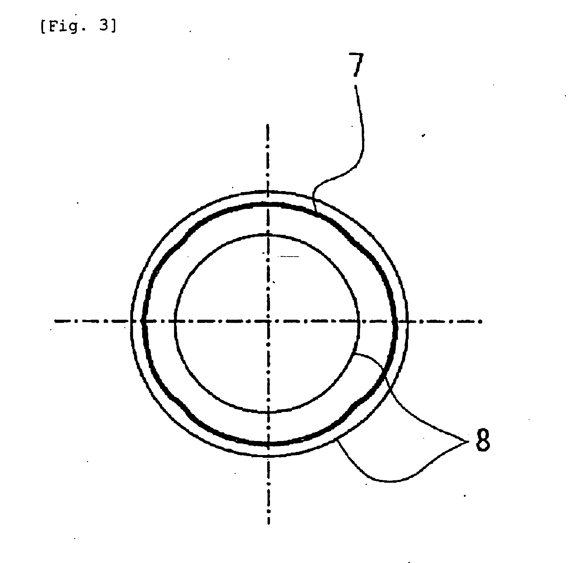

Since the four elliptical mirrors 2 are disposed on orthogonal axes, a bias of a temperature in the circumferential direction of the sample bar 4a is extremely small as shown in Fig. 3. A difference in a temperature in the circumferential direction can be 30°C or less, which depends on a shape of a lamp and a filament to be used or the like.

In the present embodiment, the four elliptical mirrors 2 are made of a glass mirror. A glass mirror has high reflection efficiency to an infrared ray, and can efficiently reflect an infrared ray emitted from the infrared lamp 3 such as a halogen lamp and a xenon lamp, whereby a satisfactorily high maximum achieving temperature can be realized.

The elliptical mirror 2 made of a glass mirror is fabricated by putting a glass plate that has been softened by heating on a ceramic mold that has been fabricated in advance, cooling the mold and the glass plate, and removing a glass mirror from the mold.

As a forming material of a glass mirror, a variety of glass materials can be used. The Pyrex (registered trademark) glass, in which a processing thereof is easy and a cost thereof is stable, is used normally. It is preferable that a material such as aluminum and gold that are excellent in an infrared ray reflective power is evaporated on an inner surface of a glass mirror, and silicon oxide or the like having a high degree of hardness is evaporated on the most outside surface of the inner surface. In the case in which a material such as aluminum and gold is evaporated on an inner surface, an infrared absorption to a glass material becomes less, and a temperature rise of a glass mirror also becomes less, thereby simplifying a cooling process. It is preferable that a thin aluminum plate is put on the outer surface side of a glass mirror in order to improve a handling property and a shock absorption property.

A growth of a single crystal in an elliptical mirror furnace 1 is carried out as described in the following for instance. A sample chamber made of a silica tube is formed in the elliptical mirror furnace 1, and the sample bar 4a is held in the silica tube. The silica tube can be in a vacuum state, or an atmospheric gas can be flown through the silica tube.

The sample bar 4a is disposed in a vertical direction in the silica tube in such a manner that the sample bar 4a passes through a focal point on a light collecting side. The upper end of the sample bar 4a is supported by a sample bar supporting part formed in a shaft shape. On the other hand, the lower end of a seed crystal that is used for growing a growth crystal is supported by a growth crystal supporting part formed in a shaft shape. Each of the supporting parts can be moved in a vertical direction and can be rotated around a bar axis by a driving apparatus via a drive part that has been mounted to the supporting part. The elliptical mirror furnace 1, the supporting parts, the drive part, and the sample chamber are held in a contained. An operator carries out the operations such as a movement of the sample bar and a control of a lamp voltage by using a'separate control panel. A CCD camera that is used for taking an image of a molten region is installed in the container. An operator observes a molten region and controls a voltage that is applied to the infrared lamp 3. The infrared lamp 3 and the elliptical mirror 2 are cooled by an air flow caused by a fan for instance.

In the case in which a growth of a single crystal is started, the end part of the sample bar 4a that is supported by a sample bar supporting part and the end part of the seed crystal that is supported by a growth crystal supporting part are disposed opposite to each other, and the silica tube is disposed. The infrared lamp 3 is then lighted, and a voltage that is applied to the infrared lamp 3 is increased by slow degrees while the sample bar and the seed crystal are rotated, whereby each of the end parts thereof is molten. At the stage in which the both end parts are molten, the end part of the sample bar 4a and the end part of the seed crystal are moved closer to each other, and the molten parts are made to be coalescent. At this time, both the sample bar 4a and the seed crystal are rotated, and a voltage that is applied to the infrared lamp 3 is controlled, whereby a size of the molten part can be controlled and a stable molten region can be formed.

After a stable molten region is formed, the sample bar 4a and the seed crystal are moved downward at the same speed (for instance, 0.1 to 100 mm/h) by the above driving apparatus. Consequently, a sample is molten and a crystal is grown continuously, whereby a growth of a single crystal formed in a bar shape is carried out.

An example of a method for growing a single crystal by using the elliptical mirror furnace 1 and an example of a configuration of an apparatus for the single crystal growth have been described above. However, the present invention is not restricted to the examples, and various changes, modifications, and functional additions can be thus made without departing from the scope of the present invention. For instance, the infrared lamp 3 and the elliptical mirror 2 can be moved in a vertical direction relatively to the sample bar 4a, thereby growing a single crystal.

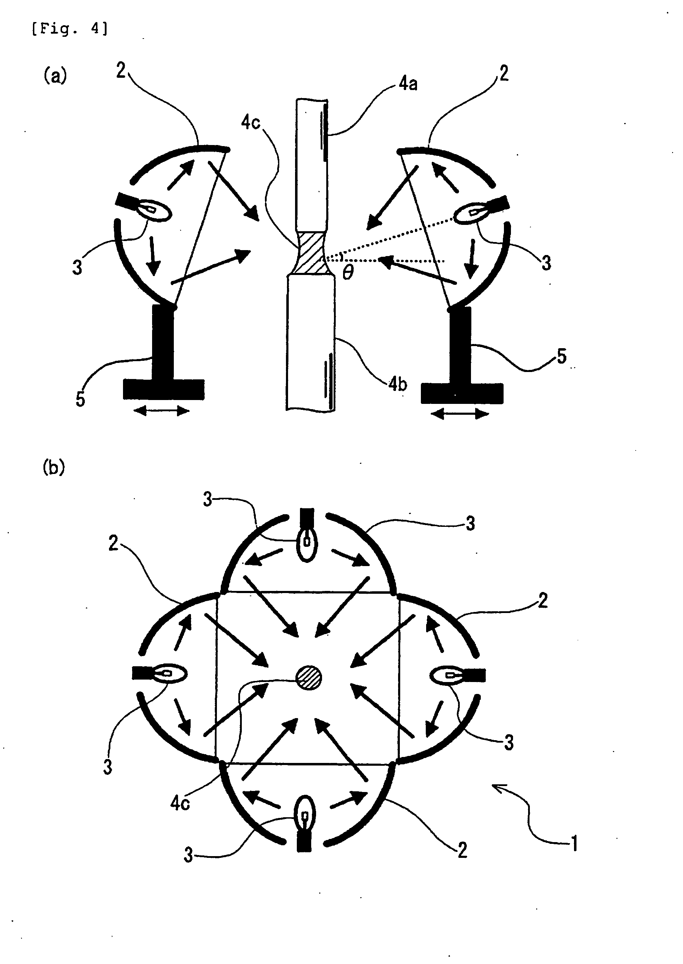

Fig. 4 is a view showing an elliptical mirror furnace of a floating zone melting apparatus in accordance with another embodiment of the present invention. Fig. 4(a) is a longitudinal cross-sectional view, and Fig. 4(b) is a transverse cross-sectional view. The floating zone melting apparatus in accordance with another embodiment of the present invention has a configuration that is suitable for growing a single crystal of a large diameter. Four elliptical mirrors 2 are disposed in such a manner that each of the four elliptical mirrors 2 is slanted downward.

By the above configuration, infrared rays that have been reflected from the reflecting surface of the elliptical mirror 2 are irradiated to a molten part 4c of a sample from an oblique upper direction. Consequently, a shape of an interface of solid and liquid phases for a growth crystal 4c and a molten part 4c becomes stable, whereby a single crystal of a'high quality can be obtained, even in the case in which a diameter of a single crystal is large. On the other hand, in the case in which four elliptical mirrors 2 are disposed in such a manner that an axis of the elliptical mirror 2 points in a horizontal direction as shown in Fig. 1, and infrared rays that have been reflected from the reflecting surface of the elliptical mirror 2 are horizontally irradiated to a molten part 4c of a sample, it is necessary to form a large amount of molten solutions to make a single crystal of a larger diameter. A molten solution is formed by the absorption of infrared rays. Even in the case in which a large amount of molten solutions is tried to be formed, it is difficult for infrared rays to reach the center thereof, whereby it is difficult to form a stable molten zone. Consequently, it is necessary to control a heating system to maintain a diameter of a molten zone to be thin in such a manner that infrared rays can reach the center of the molten zone. To form a single crystal of a large diameter, it is necessary to maintain a shape of an interface of solid and liquid phases to be flat and to stably form a molten solution on a surface of the single crystal of a large diameter. The heating from an oblique upper direction enables a shape of an interface of solid and liquid phases to be controlled and a growth of a single crystal of a large diameter to be realized.

By the floating zone melting apparatus in accordance with the embodiment of the present invention, a large-diameter single crystal having a diameter larger than 100 mm can be grown in a stable fashion. To grow a single crystal of a large diameter in a stable fashion, it is preferable that an angle θ of a straight line from the one focal point to the other focal point for the elliptical mirror 2 to the horizontal direction is 25 to 35 degrees.

Moreover, in the embodiment of the present invention, the apparatus is provided with a position control mechanism 5 for carrying out a horizontal movement of the elliptical mirror 2 in a radial direction from a position in which the sample bar 4a is disposed as a center. The position control mechanism 5 can be configured for instance by a moving member that is attached to the elliptical mirror 2 and a guide member that can guide the moving member in the radial direction and can fix the moving member at the prescribed position.

By the above position control mechanism 5, a position in a radial direction for the elliptical mirror 2 is controlled, and a focal point is set to an optimum position corresponding to a degree of a diameter of a single crystal. Therefore, a single crystal can be stably grown in an optimum optical layout corresponding to a diameter of a single crystal.

While the preferred embodiments in accordance with the present invention will be described below, the present invention is not restricted to the embodiments.

[Embodiment 1]

Four rotary ellipsoidal reflecting mirrors made of a silica glass were disposed on orthogonal axes in such a manner that one focal point was shared with each other, and a halogen lamp was disposed at the other focal point of each rotary ellipsoidal reflecting mirror to form an elliptical mirror furnace. An eccentricity of the four rotary ellipsoidal reflecting mirrors was 0.55, a diameter of an opening was 220 mm, and a ratio of a depth of the reflecting mirror to a diameter of an opening was 0.6. As the halogen lamp, a lamp of an output of 2000 W in a filament shape of a double helical structure was used.

In such a manner that a sample bar was disposed in a vertical direction at the center of the elliptical mirror furnace, a sintered sample bar was supported from the upper side by a sample bar supporting part, and a seed crystal was supported from the lower side by a growth crystal supporting part. The end part of the sample bar and the end part of the seed crystal were disposed opposite to each other.

After the silica tube was disposed around the elliptical mirror furnace, a halogen lamp was lighted. A voltage that was applied to the halogen lamp was increased by slow degrees while the sample bar and the seed crystal were rotated, and each of the end parts thereof was molten. At the stage in which the both end parts were molten, the end part of the sample bar and the end part of the seed crystal were moved closer to each other, and the molten parts were made to be coalescent. After a stable molten material was formed, while the sample bar and the seed crystal were slowly moved downward at the constant speed, a melting of a sample and a growth of a crystal were continued, whereby a growth of a single crystal in a bar shape was carried out. A molten material was enabled to be easily held, and a stable crystal growth was enabled.

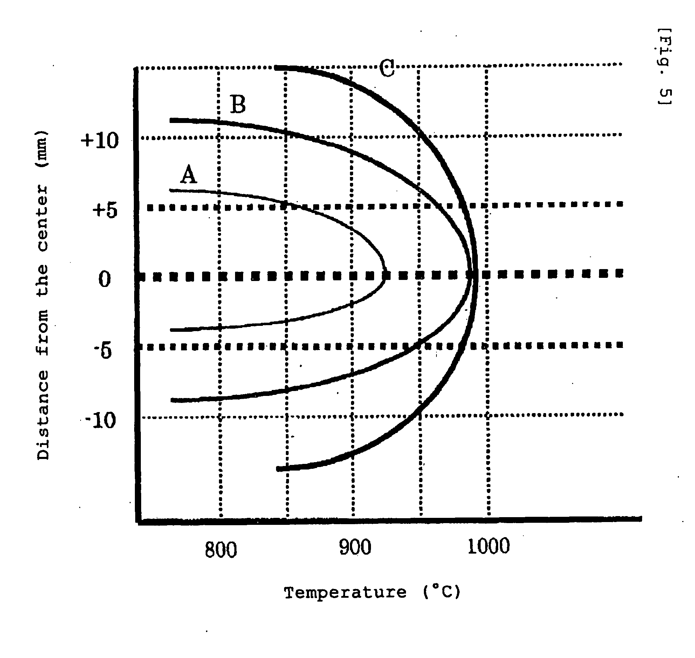

Fig. 5 shows a temperature distribution in a vertical direction (in a bar'axis direction) in the molten part. In this embodiment, a temperature distribution was indicated by a curve B shown in the figure, and a maximum achieving temperature was extremely high (approximately 1000°C). In addition, a temperature was rapidly reduced from the maximum achieving temperature in a bar axis direction. Moreover, a difference between a maximum temperature and a minimum temperature in the circumferential direction of a molten part was 30°C or less.

A temperature distribution in a vertical direction was measured by using a variety of elliptical mirrors made of a silica glass in which a ratio of a depth of the reflecting mirror to a diameter of an opening in the reflecting mirror was modified. In the case in which the ratio was in the range of 0.38 to 0.75, a satisfactorily high maximum achieving temperature can be realized similarly, and a temperature gradient in the vertical direction was steep.

[Comparative example 1]

An elliptical mirror furnace was configured under the conditions equivalent to those of Embodiment 1 except that the four rotary ellipsoidal reflecting mirrors in which an eccentricity was 0.35 and a ratio of a depth of the reflecting mirror to a diameter of an opening in the reflecting mirror was 0.8 was used. A sintered sample bar having a diameter of 20 mm was molten, and a molten material was tried to be held. However, the molten material was dropped in the very short term, and a stable molten material was not able to be formed.

Fig. 5 shows a temperature distribution in a vertical direction (in a bar axis direction) in the molten part. In this comparative example, a temperature distribution was indicated by a curve C shown in the figure, and a maximum achieving temperature was extremely high (approximately 1000°C). A temperature at a position distantly separate from a position of the maximum achieving temperature in a vertical direction is also high, and a temperature gradient was slow.

[Comparative example 2]

An elliptical mirror furnace was configured under the conditions equivalent to those of Embodiment 1 except that the four rotary ellipsoidal reflecting mirrors in which an eccentricity was 0.8 and a ratio of a depth of the reflecting mirror to a diameter of an opening in the reflecting mirror was 0.3 was used, and a single crystal was grown. A temperature at the molten part was low. A stable molten material was not able to be formed, and a single crystal of a high quality was not able to be obtained.

Fig. 5 shows a temperature distribution in a vertical direction (in a bar axis direction) in the molten part. In this comparative example, a temperature distribution was indicated by a curve A shown in the figure, and a maximum achieving temperature was extremely reduced.

[Embodiment 2]

In the apparatus in Embodiment 1, four rotary ellipsoidal reflecting mirrors were disposed in such a manner that each of the rotary ellipsoidal reflecting mirrors was slanted downward as shown in Fig. 4. An angle θ of a straight line from the one focal point to the other focal point for the rotary ellipsoidal reflecting mirror to the horizontal direction was 30 degrees. Infrared rays that were reflected from the reflecting surface of the rotary ellipsoidal reflecting mirror were irradiated to a molten part of a sample from an oblique upper direction.

In such a manner that a sample bar was disposed in a vertical direction at the center of the elliptical mirror furnace, a sintered sample bar having a diameter of 25 mm was supported from the upper side by a sample bar supporting part, and a seed crystal was supported from the lower side by a growth crystal supporting,part. A molten material was formed similarly to Embodiment 1. While the elliptical mirror furnace was slowly moved upward at the constant speed, the sintered sample bar was slowly moved downward at the constant speed, and a melting of a sample and a growth of a crystal were continued. As a result, a shape of an interface of solid and liquid phases for a growth crystal and a molten part was not so convex, and a single crystal having a diameter of 50 mm was able to be grown in a stable fashion.

**Claims**

1.  A floating zone melting apparatus of an infrared intensive heating system, comprising infrared lamps (3) disposed at one focal point of four rotary ellipsoidal reflecting mirrors (2) that are disposed opposite to each other on orthogonal axes with an inner face used as a reflecting surface, in which infrared rays reflected from the reflecting surface are collected to the other focal point to heat a sample, wherein:

    an eccentricity of the rotary ellipsoidal reflecting mirror is in the range of 0.40 to 0.65, and a ratio of a depth of the reflecting mirror to a diameter of an opening in the reflecting mirror is in the range of 0.38 to 0.75.

2.  The floating zone melting apparatus as defined in claim 1, wherein the rotary ellipsoidal reflecting mirror (2) is a glass mirror.

3.  The floating zone melting apparatus as defined in claim 1 or 2, wherein the rotary ellipsoidal reflecting mirror (2) is disposed in such a manner that a straight line from the one focal point to the other focal point is slanted downward by 25 to 35 degrees in the horizontal direction, and infrared rays reflected from the reflecting surface are irradiated to a sample from an oblique upper direction.

4.  The floating zone melting apparatus as defined in claim 3, wherein six or eight rotary ellipsoidal reflecting mirrors (2) are disposed at equal spaces.

5.  The floating zone melting apparatus as defined in claim 3, further comprising a position control mechanism (5) for a horizontal movement of the rotary ellipsoidal reflecting mirror (2) in a radial direction from a position in which the sample is disposed as a center.

6.  The floating zone melting apparatus as defined in claim 3, further comprising a heating part is disposed on a lower side of a crystal growth part.

7.  The floating zone melting apparatus as defined in claim 3, further comprising a raw material melting furnace disposed on the upper side of the apparatus and a mechanism for dropping and supplying a molten raw material to the crystal growth part as needed.

8.  The floating zone melting apparatus as defined in claim 7, further comprising a raw material introduction pipe or a raw material introduction bar for supplying a molten raw material from the raw material melting furnace disposed on the upper side of the apparatus to the crystal growth part.

9.  The floating zone melting apparatus as defined in claim 3, further comprising a mechanism for controlling arbitrary pressure from a vacuum to a high pressure to the crystal growth part, a raw material molten part, and a raw material supplying part, and a mechanism for controlling an atmosphere using any gas from an oxidation gas to a reducing gas to the crystal growth part, the raw material molten part, and the raw material supplying part.

**Patentansprüche**

1.  Fließzonenschmelzvorrichtung eines Infrarotintensivheizsystems, umfassend Infrarotlampen (3), welche in einem Brennpunkt von vier elliptischen Dreh-Reflektionsspiegeln (2) angeordnet sind, die sich auf orthogonalen Achsen mit der als Reflektionsoberfläche genutzten Innenseite gegenüberstehen, in welchem von der Reflektionsoberfläche reflektierte Infrarotstrahlen am anderen Brennpunkt gesammelt werden, um eine Probe zu erhitzen, wobei:

    eine Exzentrität des elliptischen Dreh-Reflektionsspiegels im Bereich von 0,40 bis 0,65 ist, und ein Verhältnis der Tiefe des Reflektionsspiegels zu einem Durchmesser einer Öffnung in dem Reflektionsspiegel im Bereich von 0,38 bis 0,75 ist.

2.  Fließzonenschmelzvorrichtung gemäß Anspruch 1, wobei der elliptische Dreh-Reflektionsspiegel (2) ein Glasspiegel ist.

3.  Fließzonenschmelzvorrichtung gemäß Anspruch 1 oder 2, wobei der elliptische Dreh-Reflektionsspiegel (2) in einer solchen Weise angeordnet ist, dass eine gerade Linie von einem Brennpunkt zum anderen Brennpunkt um 25 bis 35 Grad in horizontaler Richtung nach unten geneigt ist, und von der Reflektionsoberfläche reflektierte Infrarotstrahlen von einer schrägen oberen Richtung auf eine Probe abgestrahlt werden.

4. Fließzonenschmelzvorrichtung gemäß Anspruch 3, wobei sechs oder acht elliptische Dreh-Reflektionsspiegel (2) mit gleichen Zwischenräumen angeordnet werden.

5. Fließzonenschmelzvorrichtung gemäß Anspruch 3, des Weiteren umfassend einen Positionssteuerungsmechanismus (5) für eine Horizontalbewegung des elliptischen Dreh-Reflektionsspiegels (2) in einer radialen Richtung von einer Position, in welcher die Probe als ein Zentrum angeordnet wird.

6. Fließzonenschmelzvorrichtung gemäß Anspruch 3, des Weiteren umfassend ein Heizteil, welches an einer unteren Seite eines Kristallwachstumsteils angeordnet ist.

7. Fließzonenschmelzvorrichtung gemäß Anspruch 3, des Weiteren umfassend einen Rohmaterialschmelzofen, welcher auf der Oberseite der Vorrichtung angeordnet ist, und einen Mechanismus zum Fallenlassen und Bereitstellen von geschmolzenem Rohmaterial zum Kristallwachstumsteil, wie dies benötigt wird.

8. Fließzonenschmelzvorrichtung gemäß Anspruch 7, des Weiteren umfassend eine Rohmaterialeinführungsröhre oder eine Rohmaterialeinführungsstange zum Bereitstellen von geschmolzenem Rohmaterial von dem Rohmaterialschmelzofen, welcher auf der Oberseite der Vorrichtung angeordnet ist, zum Kristallwachstumsteil.

9. Fließzonenschmelzvorrichtung gemäß Anspruch 3, des Weiteren umfassend einen Mechanismus zum beliebigen Steuern des Drucks von einem Vakuum zu einem Hochdruck an dem Kristallwachstumsteil, einen Rohmaterialschmelzteil, und einen Rohmaterialbereitstellungsteil, und einen Mechanismus zum Steuern einer Atmosphäre unter Benutzung eines beliebigen Gases von einem Oxidationsgas bis zu einem Reduktionsgas an dem Kristallwachstumsteil, dem Rohmaterialschmelzteil, und dem Rohmaterialbereitstellungsteil.

**Revendications**

1. Appareil de fusion à zone flottante d'un système de chauffage intensif infrarouge, comprenant des lampes infrarouges (3) disposées à un point focal de quatre miroirs réfléchissants ellipsoïdaux rotatifs (2) qui sont disposés à l'opposé l'un de l'autre sur des axes orthogonaux avec une face intérieure utilisée comme surface réfléchissante, dans lequel les rayons infrarouges réfléchis de la surface réfléchissante sont collectés à l'autre point focal pour chauffer un échantillon, dans lequel :

une excentricité du miroir réfléchissant ellipsoïdal rotatif est dans la plage de 0,40 à 0,65, et un rapport d'une profondeur du miroir réfléchissant sur un diamètre d'une ouverture dans le miroir réfléchissant est dans la plage de 0,38 à 0,75.

2. Appareil de fusion à zone flottante selon la revendication 1, dans lequel le miroir réfléchissant ellipsoïdal rotatif (2) est un miroir en verre.

3. Appareil de fusion à zone flottante selon la revendication 1 ou 2, dans lequel le miroir réfléchissant ellipsoïdal rotatif (2) est disposé de telle manière qu'une ligne droite d'un point focal à l'autre point focal est inclinée vers le bas de 25 à 35 degrés dans la direction horizontale, et les rayons infrarouges réfléchis de la surface réfléchissante sont irradiés sur un échantillon à partir d'une direction supérieure oblique.

4. Appareil de fusion à zone flottante selon la revendication 3, dans lequel six ou huit miroirs réfléchissants ellipsoïdaux rotatifs (2) sont disposés à des espaces égaux.

5. Appareil de fusion à zone flottante selon la revendication 3, comprenant en outre un mécanisme de commande de position (5) pour un mouvement horizontal du miroir réfléchissant ellipsoïdal rotatif (2) dans une direction radiale à partir d'une position à laquelle l'échantillon est disposé en tant que centre.

6. Appareil de fusion à zone flottante selon la revendication 3, comprenant en outre une partie de chauffage disposée sur un côté inférieur d'une partie de croissance de cristal.

7. Appareil de fusion à zone flottante selon la revendication 3, comprenant en outre un four de fusion de matière première disposé sur le côté supérieur de l'appareil et un mécanisme pour faire tomber et fournir une matière première fondue dans la partie de croissance de cristal selon les besoins.

8. Appareil de fusion à zone flottante selon la revendication 7, comprenant en outre un tuyau d'introduction de matière première ou une barre d'introduction de matière première pour fournir une matière première fondue en provenance du four de fusion de matière première, disposé sur le côté supérieur de l'appareil dans la partie de croissance de cristal.

9. Appareil de fusion à zone flottante selon la revendication 3, comprenant en outre un mécanisme de contrôle de pression arbitraire, depuis un vide jusqu'à une haute pression dans la partie de croissance de cristal, une partie de fusion de matière première et une partie de fourniture de matière première, et un mécanisme de contrôle d'une atmosphère en utilisant n'importe quel gaz, depuis un gaz d'oxydation jusqu'à un gaz de réduction dans la partie de croissance de cristal, la partie de fusion de matière première et la partie de fourniture de matière première.

[Fig. 1]

(a)

(b)

[Fig. 2]

[Fig. 3]

[Fig. 4]

(a)

(b)

[Fig. 5]

[Fig. 6]

(a)

(b)

Lamp side

[Fig. 7]

(a)

(b)

Lamp side ——————— Lamp side

[Fig. 8]

[Fig. 9]

(a)

(b)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9235171 A
- EP 0768391 A